# EUROPEAN PATENT APPLICATION

(11) **EP 3 460 577 A1**
(43) Date of publication of application: **27.03.2019**
(21) Application number: 18196320.8
(22) Date of filing: 24.09.2018
(51) Int. Cl.: G03F 7/30, H01L 21/67

(54) **SOLVENT DISTRIBUTION SYSTEM FOR PROCESSING FLEXOGRAPHIC PRINTING PLATES**

(30) Priority: 25.09.2017 DK PA201770725
(71) Applicant: Glunz & Jensen A/S, 4100 Ringsted (DK)
(72) Inventor: Jensen, Peter, 4100 Ringsted (DK); Nedergaard, Stig, 4100 Ringsted (DK); Newman, Frank, 4100 Ringsted (DK)
(74) Representative: Orsnes, Henrik Egede

(57) **Abstract**

There is provided a solvent distribution system for washing/cleaning flexographic printing plates. More specifically the invention relates to a nozzle based solvent distribution device to ensure a better and more uniform solvent flow in order to achieve a homogeneous washout.

## Description

### FIELD OF THE INVENTION

The present invention relates to a solvent distribution system for washing/cleaning flexographic printing plates. More specifically the invention relates to a nozzle based solvent distribution device to ensure a better and more uniform solvent flow in order to achieve a homogeneous washout.

### BACKGROUND OF THE INVENTION

In known apparatuses the printing plate to be treated contacts the liquid contained in a vessel, of which the wash-out quality steadily decreases as a consequence of the use of the active contents of the liquid and the pollution of the liquid by particles washed out or dissolved from the plates to be treated.

In a known device of this type the printing plates are pulled through the device with rotating brushes for removing the photopolymers not polymerized during a previous exposure so that, depending on the design of the printing plate, at the end of the washing out process a positive or negative image remains in the form of relief on the printing plate.

During the process a printing plate must be cleaned free of all polymer. Polymer particles adhering to the printing plates can impair the printed result achieved. It is the aim of the present invention to improve the cleaning of the printing plates by providing an improved solvent distribution to the brushes.

In addition, conventional brush-based processing suffers from substantially increased polymer and/or monomer concentration locally in the area where brush action is carried out. Such locally increased polymer/monomer concentration causes locally high viscosity and locally high saturation of the liquid, thus causing reduction of wash-out efficiency on the plate. Moreover, the wash-out efficiency may be influenced by insufficient solvent distribution and the tendency of solvent foaming. These problems still remain partially unsolved.

Due to the uncontrolled solvent distribution on the plate to be treated, known machines cannot effectively remove the non-polymerized portions efficiently. In particular they do not provide an even cleaning of all the points of the surface of the printing plate to be treated due to varying degrees of polymer contamination.

Therefore the object of the present invention is to provide a machine free from said drawbacks. This object is achieved by means of a novel solvent distribution system for the treatment of printing plates having the main characteristics disclosed in the first claim and other characteristics disclosed in the subsequent claims.

Therefore the object of the present invention is to provide a solvent distribution system free from the above discussed drawbacks. This object is achieved by means of a system in accordance with the claims.

### SUMMARY OF THE INVENTION

The washing or chemically processing of the flexographic printing plate is decisive for obtaining a high quality product. The plate is transported continuously through the closed housing by means of pairs of rollers or by being attached to a pin bar that is attached to a chain, and then washed out, cleaned and partially dried printing plate is then ready to be dried. The non-exposed material is washed out by means of brushes and the washout solution is normally fed to the brushes.

The present invention provides an improved solvent distribution system with an inner and an outer tube. The inner tube's function is to spread the solvent into the outer tube which by lowering the pressure produces a smooth flow. This results in a uniform flow to prevent foaming issues.

Specifically the present invention provides a nozzle based solvent distribution system for washing flexographic printing plates, said system comprising:
- an outer tube having a first and a second end and provided with a plurality of holes evenly distributed along the length of the outer tube, said holes having a diameter ranging from 2 to 15 mm;
- an inner tube placed coaxially within the outer tube and having a first and a second end and provided with a plurality of holes evenly distributed along the length of the inner tube said holes having a diameter ranging from 2 to 15 mm;
- an end cap for closing a second end of the inner and outer tubes, with a screw being fastened by engaging with the interior part of the inner tube's second end;
- a solvent reservoir in fluid contact with the inner tube;
- an end cap for closing the first end of the inner and outer tubes and provided with a fluid conduit for establishing a fluid connection between the inner tube and the solvent reservoir;
- a pump for pumping pressurized solvent from the solvent reservoir to the inner tube, whereby the solvent is spread into the outer tube thereby lowering the pressure to obtain a smooth flow of solvent.

In a preferred embodiment of the present invention the holes of the inner tube is provided equidistantly with a distance between the center of each hole ranging from 30 to 300 mm. Similarly the holes of the outer tube is preferably provided equidistantly with a distance between the center of each hole ranging from 30 to 300 mm.

Concerning the holes of the inner tube and the holes of the outer tube these should preferably be misaligned in order for the solvent to properly distribute within the outer tube before leaving the system. This is preferably achieved by ensuring that the holes of the inner tube are twisted between 90 and 270 degrees relative to the holes of the outer tube.

In order to facilitate access to the interior of the system, e.g. for inspection or cleaning purposes, the end cap screw is preferably a screw (or bolt), which engage with the inner tube via a thread mechanism.

In order to achieve the most homogeneous distribution of the solvent and avoid undesired foaming the pump is preferably configured to produce a pressure in the inner tube of between 1 and 10 bar.

Also to achieve the best results the distance between the outer surface of the inner tube and inner surface of the outer tube should be in the range of 1 to 8 mm. Likewise the diameter of the inner tube preferably ranges from 5 to 15 and the diameter of the outer tube ranges from 10 to 40.

### BRIEF DESCRIPTION OF THE DRAWINGS

Figure 1 shows a perspective view of an apparatus for treating flexographic printing plates.
Figure 2 shows a cross sectional view of the solvent distribution system.

### DETAILED DESCRIPTION OF THE INVENTION

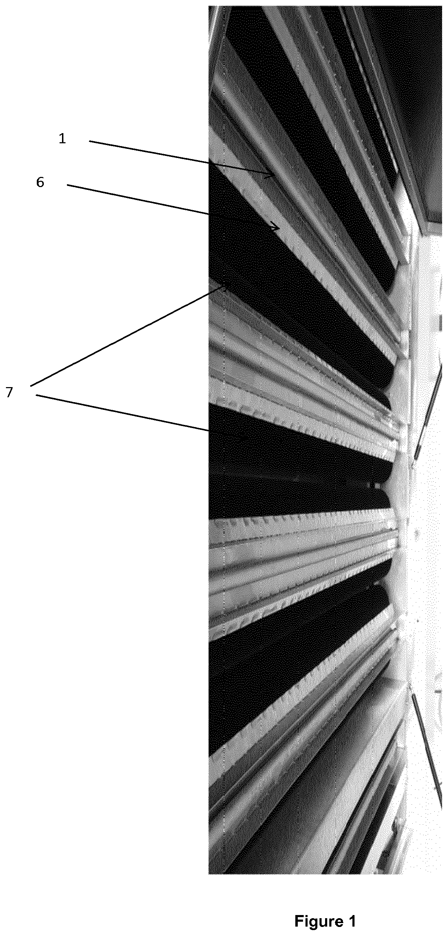

In Figure 1 there is shown a part of an apparatus for treating / washing flexographic printing plates in which the solvent distribution system of the present invention has been implemented. As shown with (1) the outer tubes of the system are mounted in distribution baths (6) for directing the solvent to the brushes (7).

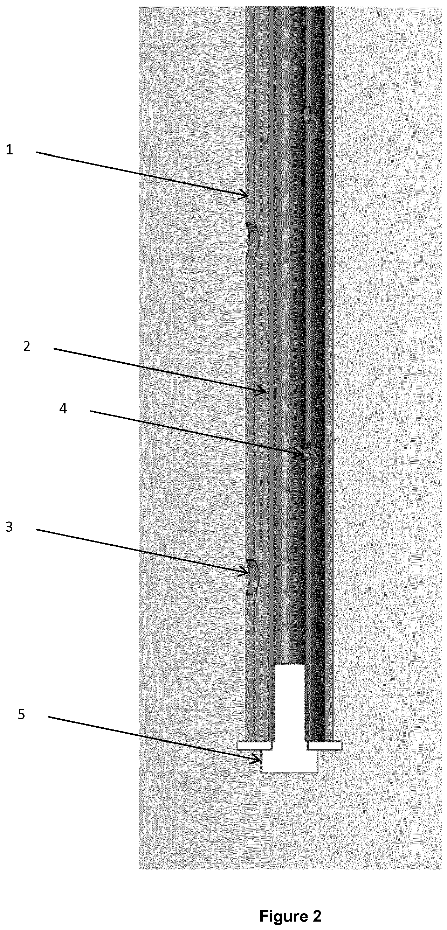

Referring to Figure 2 there is shown the solvent distribution system of the present invention for processing a printing plate with a liquid. The nozzle based solvent distribution system comprises the outer tube (1) having a first and a second end and provided with a plurality of holes (3) evenly distributed along the length of the outer tube (1). The inner tube (2) is placed coaxially within the outer tube (1) with a plurality of holes (4) evenly distributed along the length of the inner tube (2). The end cap (5) closes the second end of the inner and outer tubes.

## Claims

1. A nozzle based solvent distribution system for washing flexographic printing plates, said system comprising:
- an outer tube (1) having a first and a second end and provided with a plurality of holes (3) evenly distributed along the length of the outer tube (1), said holes having a diameter ranging from 2 to 15 mm;
- an inner tube (2) placed coaxially within the outer tube (1) and having a first and a second end and provided with a plurality of holes (4) evenly distributed along the length of the inner tube (2) said holes having a diameter ranging from 2 to 15 mm;
- an end cap (5) for closing the second end of the inner and outer tubes;
- a solvent reservoir in fluid contact with the inner tube (2);
- an end cap for closing the first end of the outer (1) tube and a fluid conduit for establishing a fluid connection between the inner tube (2) and the solvent reservoir;
- a pump for pumping pressurized solvent from the solvent reservoir to the inner tube, whereby the solvent is spread into the outer tube thereby lowering the pressure to obtain a smooth flow of solvent.

2. The solvent distribution system of claim 1, wherein the holes (4) of the inner tube (2) are provided equidistantly with a distance between the center of each hole (4) ranging from 50 to 200 mm.

3. The solvent distribution system of claim 1 or 2, wherein the holes (3) of the outer tube (1) are provided equidistantly with a distance between the center of each hole ranging from 50 to 200 mm.

4. The solvent distribution system of any one of the claims 1-3, wherein lengths of the inner (2) and outer (1) tubes ranges from 500 to 1500 mm.

5. The solvent distribution system of any one of the claims 1-4, wherein the holes (4) of the inner tube (2) and the holes (3) of the outer tube (1) are misaligned.

6. The solvent distribution system of any one of the claims 1-5, wherein the holes (4) of the inner tube (2) are twisted between 90 and 270 degrees relative to the holes (3) of the outer tube (1).

7. The solvent distribution system of any one of the claims 1-6, wherein the end cap (5) has a threaded part that engages with the inner or outer tube.

8. The solvent distribution system of any one of the claims 1-7, wherein the pump is configured to produce a pressure in the inner tube of between 2 and 8 bar.

9. The solvent distribution system of any one of the claims 1-8, wherein the distance between the outer surface of the inner tube (2) and inner surface of the outer tube (1) is in the range of 2 to 6mm.

10. The solvent distribution system of any one of the claims 1-9, wherein the diameter of the inner tube (2) ranges from 6 to 12 and the diameter of the outer tube (1) ranges from 15 to 35mm.
